# EUROPEAN PATENT APPLICATION

(11) **EP 4 579 264 A1**
(43) Date of publication of application: **02.07.2025**
(21) Application number: 24222896.3
(22) Date of filing: 23.12.2024
(51) Int. Cl.: G01R 33/26

(54) **CALIBRATION OF AN OPTICALLY PUMPED MAGNETOMETER**

(30) Priority: 26.12.2023 IL 30974323
(71) Applicant: Elta Systems Ltd., Ashdod 7710201 (IL)
(72) Inventor: ROSENZWEIG, Yossi, 7710201 Ashdod (IL); SHCHERBACK, Igor, 7710201 Ashdod (IL); TOKAR, Dima, 7710201 Ashdod (IL)
(74) Representative: Arnold & Siedsma

(57) **Abstract**

An optically pumped magnetometer (OPM) having a vapor chamber, a light source configured to supply light to the vapor chamber, a detector positioned to measure light emitted from the vapor chamber, and including: calibration circuitry configured to generate magnetic fields having a plurality frequencies across the vapor chamber; and a controller operatively coupled to the calibration circuitry and configured to, in a calibration mode: generate a calibration circuitry control signal configured to drive the calibration circuitry to sequentially to generate a set of known magnetic fields with predefined frequencies; receive, from the detector, a plurality of detector measurements, each measurement corresponding to a known magnetic field of the set; determine a calibration error of the OPM using the set of known magnetic fields and the plurality of detector measurements.

## Description

### TECHNOLOGICAL FIELD

The present disclosure, in some embodiments, thereof, relates to optically pumped magnetometers (OPMs) and, more particularly, but not exclusively, to calibration of OPMs.

### GENERAL DESCRIPTION

Following is a non-exclusive list of some exemplary embodiments of the disclosure. The present disclosure also includes embodiments which include fewer than all the features in an example and embodiments using features from multiple examples, even if not listed below.

Example 1. An optically pumped magnetometer (OPM) having a vapor chamber, a light source configured to supply light to said vapor chamber, a detector positioned to measure light emitted from said vapor chamber, and comprising:
calibration circuitry configured to generate magnetic fields having a plurality frequencies across said vapor chamber; and
a controller operatively coupled to the calibration circuitry and configured to, in a calibration mode:
   generate a calibration circuitry control signal configured to drive said calibration circuitry to sequentially to generate a set of known magnetic fields with predefined frequencies;
   receive, from said detector, a plurality of detector measurements, each measurement corresponding to a known magnetic field of said set;
   determine a calibration error of said OPM using said set of known magnetic fields and said plurality of detector measurements.

Example 2. The OMP according to Example 1, wherein said controller is configured to adjust one or more operational parameter of said OPM to reduce said calibration error.

Example 3. The OPM according to any one of Examples 1-2, wherein said controller is configured to determine said calibration error by:
processing said plurality of detector measurements to determine a plurality of magnetic field measurements; and
comparing said plurality of magnetic field measurements with said set of known magnetic fields.

Example 4. The OPM according to Example 3, wherein said controller is configured to adjust said processing to reduce said calibration error.

Example 5. The OPM according to Example 4, wherein said processing comprises fitting an ideal function to each said set, where said magnetic field measurement is extracted using said fitted ideal function.

Example 6. The OPM according to Example 5, wherein said controller is configured to adjust one or more parameter of said fitting.

Example 7. The OPM according to any one of Examples 5-6, wherein said processing comprises truncating said measurement data.

Example 8. The OMP according to any one of Examples 1-7, comprising a housing hosting at least said vapor chamber, and said calibration circuitry.

Example 9. The OPM according to Example 8, wherein said housing hosts said light source and said detector.

Example10. The OPM according to any one of Examples 1-9, wherein said controller is configured to:
receive calibration parameters from a memory;
generate said calibration circuitry control signal using said calibration parameters.

Example 11. The OPM according to any one of Examples 2-10, wherein said controller is configured to:
extract, for each of said plurality of detector measurements, a resonance frequency; and
determine a magnetic field measurement from said resonance frequency.

Example 12. The OPM according to Example 11, wherein when said OPM is in said calibration mode, said controller is configured to iteratively perform generation and measurement of known magnetic fields, and adjustment of said one or more operational parameter of said magnetometer and/or to perform adjustment of processing of detector measurements until said calibration error is below a threshold.

Example 13. The OPM according to any one of Examples 11-12, wherein said controller is configured to:
control a modulation signal;
extract, for each of said plurality of detector measurements, said resonance frequency, using said modulation signal.

Example 14. The OPM according to Example 13, wherein said modulation signal is a signal configured to modulate a frequency of light emitted by said light source.

Example 15. The OPM according to Example 13, wherein said modulation signal is a signal configured to modulate a frequency of microwaves emitted by a microwave antenna.

Example 16. The OPM according to any one of Examples 1-15, wherein said controller is configured to determine a calibration error for each of said set of known magnetic fields by comparison with a corresponding magnetic field measurement.

Example 17. The OPM according to any one of Examples 1-16, wherein said predefined frequencies are distributed within a calibration magnetic signal bandwidth; and
wherein said calibration magnetic signal bandwidth corresponds to a desired measurement bandwidth of said OPM.

Example 18. The OPM according to Example 17, wherein said calibration circuitry comprises at least one element providing an additional function, wherein, when said at least one element is driven to provide said additional function, magnetic fields generated are outside said calibration magnetic signal bandwidth.

Example 19. The OPM according to any one of Examples 17-18, wherein said magnetic fields generated are of frequencies above 1kHz.

Example 20. The OPM according to any one of Examples 17-19, wherein said magnetic fields generated are of frequencies above 3kHz.

Example 21. The OPM according to any one of Examples 17-20, wherein said measurement bandwidth of said OPM includes frequencies below 1kHz.

Example 22. The OPM according to any one of Examples 17-21, wherein said measurement bandwidth of said OPM includes frequencies above 3kHz.

Example 23. The OPM according to any one of Examples 18-22, wherein said at least one element comprises heating circuitry configured to control temperature of said vapor chamber.

Example 24. The OPM according to any one of Examples 18-23, wherein said at least one element comprises microwave antenna circuitry configured to generate microwaves to induce magnetic resonance within said vapor chamber.

Example 25. The OPM according to any one of Examples 1-24, wherein said calibration circuitry is adjacent to said vapor chamber without magnetically shielding material therebetween.

Example 26. The OPM according to any one of Examples 2-25, wherein said one or more operational parameter includes:
one or more parameter of said light source, one or more parameter of said detector.

Example 27. The OPM according to any one of Examples 1-26, wherein said set of known magnetic fields comprise pulses having one or more of a known time and a known duration;
wherein said controller is configured to extract, for one or more pulse, a corresponding detector measurement, using said known time and/or known duration.

Example 28. The OPM according to any one of Examples 1-27, wherein said set of known magnetic fields have higher amplitude than fields to be measured by said OPM.

Example 29. A method of optically pumped magnetometer (OPM) calibration to be performed in the field comprising:
driving calibration circuitry of the OPM to sequentially generate a set of known magnetic fields with predefined frequencies;
receiving, from a detector of the OPM, a plurality of detector measurements, each measurement corresponding to a known magnetic field of said set;
determining a calibration error of said OPM using said set of known magnetic fields and said plurality of detector measurements.

Example 30. The method according to Example 29, comprising adjusting one or more operational parameter of said OPM to reduce said calibration error.

Example 31. The method according to Example 30, comprising repeating said driving, said receiving, said determining, and said adjusting until said calibration error is below a threshold.

Example 32. The method according to any one of Examples 29-31, comprising:
driving said calibration circuitry to perform an additional function, said driving to perform said additional function generating magnetic fields outside a measurement bandwidth of said OPM.

Example 33. The method according to Example 32, wherein said additional function includes heating a vapor chamber of said OPM.

Example 34. The method according to Example 32, wherein said additional function includes generating a microwave signal configured to stimulate magnetic resonance within a vapor chamber of said OPM.

Example 35. The method according to any one of Examples 29-34, comprising receiving calibration parameters from a memory;
wherein said generating comprises generating said calibration circuitry control signal using said calibration parameters.

Example 36. The method according to Example 35, comprising determining said calibration parameters by:
driving said calibration circuitry with known driving signals;
measuring generated magnetic fields using an additional magnetometer to produce magnetic field measurements; and
determining said calibration parameters from said known driving signals and said magnetic field measurements.

Unless otherwise defined, all technical and/or scientific terms used within this document have meaning as commonly understood by one of ordinary skill in the art/s to which the present disclosure pertains. Methods and/or materials similar or equivalent to those described herein can be used in the practice and/or testing of embodiments of the present disclosure, and exemplary methods and/or materials are described below. Regarding exemplary embodiments described below, the materials, methods, and examples are illustrative and are not intended to be necessarily limiting.

Some embodiments of the present disclosure are embodied as a system, method, or computer program product. For example, some embodiments of the present disclosure may take the form of an entirely hardware embodiment, an entirely software embodiment (including firmware, resident software, micro code, etc.) or an embodiment combining software and hardware aspects that may all generally be referred to herein as a "circuit," "module" and/or "system."

Implementation of the method and/or system of some embodiments of the present disclosure can involve performing and/or completing selected tasks manually, automatically, or a combination thereof. According to actual instrumentation and/or equipment of some embodiments of the method and/or system of the present disclosure, several selected tasks could be implemented by hardware, by software or by firmware and/or by a combination thereof, e.g., using an operating system.

For example, hardware for performing selected tasks according to some embodiments of the present disclosure could be implemented as a chip or a circuit. As software, selected tasks according to some embodiments of the present disclosure could be implemented as a plurality of software instructions being executed by a computational device e.g., using any suitable operating system.

In some embodiments, one or more tasks according to some exemplary embodiments of method and/or system as described herein are performed by a data processor, such as a computing platform for executing a plurality of instructions. Optionally, the data processor includes a volatile memory for storing instructions and/or data and/or a non-volatile storage e.g., for storing instructions and/or data. Optionally, a network connection is provided as well. User interface/s e.g., display/s and/or user input device/s are optionally provided.

Some embodiments of the present disclosure may be described below with reference to flowchart illustrations and/or block diagrams. For example illustrating exemplary methods and/or apparatus (systems) and/or and computer program products according to embodiments of the present disclosure. It will be understood that each step of the flowchart illustrations and/or block of the block diagrams, and/or combinations of steps in the flowchart illustrations and/or blocks in the block diagrams, can be implemented by computer program instructions. These computer program instructions may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the flowchart steps and/or block diagram block or blocks.

These computer program instructions may also be stored in a computer readable medium that can direct a computer (e.g., in a memory, local and/or hosted at the cloud), other programmable data processing apparatus, or other devices to function in a particular manner, such that the instructions stored in the computer readable medium can be used to produce an article of manufacture including instructions which implement the function/act specified in the flowchart and/or block diagram block or blocks.

The computer program instructions may also be run by one or more computational device to cause a series of operational steps to be performed e.g., on the computational device, other programmable apparatus and/or other devices to produce a computer implemented process such that the instructions which execute provide processes for implementing the functions/acts specified in the flowchart and/or block diagram block or blocks.

Some of the methods described herein are generally designed only for use by a computer, and may not be feasible and/or practical for performing purely manually, by a human expert. A human expert who wanted to manually perform similar tasks, might be expected to use different methods, e.g., making use of expert knowledge and/or the pattern recognition capabilities of the human brain, potentially more efficient than manually going through the steps of the methods described herein.

### BRIEF DESCRIPTION OF THE DRAWINGS

In order to better understand the subject matter that is disclosed herein and to exemplify how it may be carried out in practice, embodiments will now be described, by way of non-limiting example only, with reference to the accompanying drawings, in which:
FIG. 1 is a simplified schematic of a magnetometer, according to some embodiments of the disclosure;
FIG. 2 is a method of calibration, according to some embodiments of the disclosure;
FIG. 3 is a simplified schematic illustrating relative frequencies and amplitudes of exemplary magnetic fields, according to some embodiments of the disclosure;
FIG. 4 illustrates a method of calibration, according to some embodiments of the disclosure; and
FIG. 5 is a simplified schematic of a magnetometer, according to some embodiments of the disclosure.

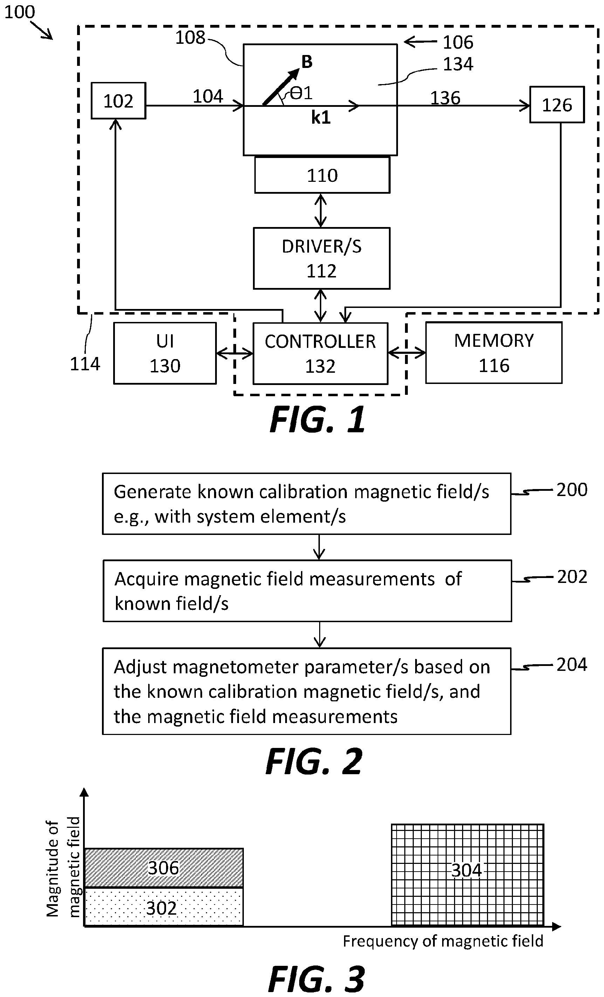

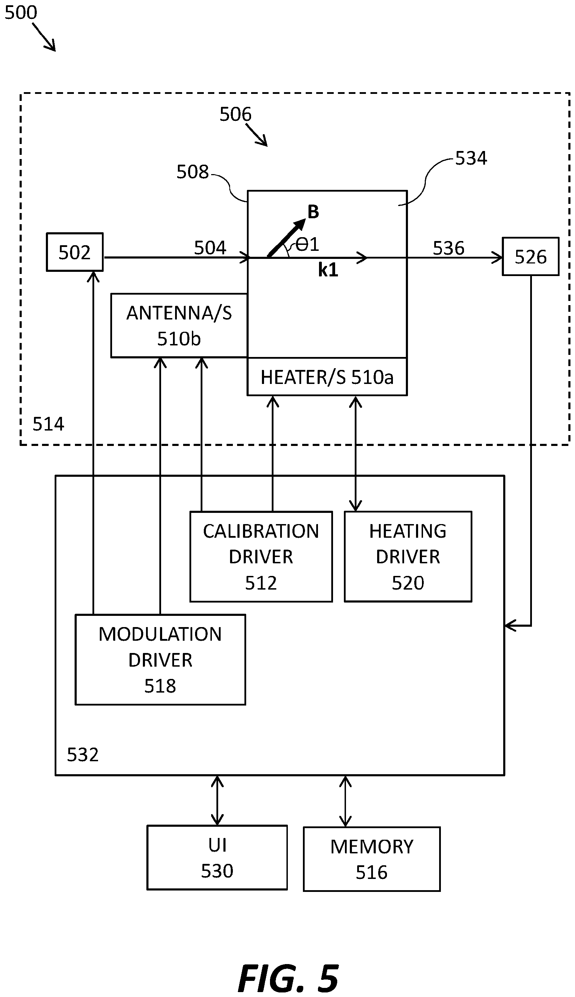

In some embodiments, although non-limiting, in different figures, like numerals are used to refer to like elements, for example, element 102 in FIG. 1 corresponding to element 502 in FIG. 5.

### DETAILED DESCRIPTION OF EMBODIMENTS

The present disclosure, in some embodiments, thereof, relates to optically pumped magnetometers (OPMs) and, more particularly, but not exclusively, to calibration of OPMs.

### Overview

A broad aspect of some embodiments of the disclosure relates to field calibration of optically pumped magnetometers (OPMs), where the magnetometer itself includes calibration circuitry configured to generate known magnetic fields to be used for calibration of magnetometer measurements. In some embodiments, the calibration circuitry is housed within a magnetometer housing. In some embodiments, the calibration circuitry is not magnetically isolated from a vapor chamber of the magnetometer.

A potential advantage of the magnetometer having self-calibration circuitry is the ability to calibrate magnetic field measurement/s and/or adjust magnetometer functionality when magnetometer parameter/s drift and/or where measurement become inaccurate for extreme operating conditions (e.g., the magnetic field to be measured has high gradient and/or extreme (high/low) absolute magnitude of magnetic field ) for example, when the magnetometer is employed away from a controlled environment e.g., in "the field". Where exemplary parameters potentially prone to drift include one or more of laser power, laser wavelength, vapor cell temperature, parameter/s of digital signal processing of measurement/s, sensor/s operating in the wrong regime.

For example, where the magnetometer is used to scan an environment for magnetic anomalies, without the ability to perform self-calibration, drift in parameter/s and/or inaccuracy in measurement may not be identified. Where a magnetometer is used to scan an environment of magnetic anomalies, in regions lacking an anomaly the magnetometer measures a constant (e.g., associated with Earth's magnetic field) along with noise. However, if the magnetometer has drifted to a mode where magnetic fields are attenuated and/or where the magnetometer is working in a harsh and/or extreme environment, the noise signal will also be attenuated, but this attenuation may not be identified as the attenuated noise measurements, for example, could be understood to be reflective of a low-noise environment.

An aspect of some embodiments of the disclosure relates to a magnetometer having calibration circuitry configured to be driven to produce known magnetic fields where the calibration circuitry also provides other functionality to the magnetometer and/or where existing magnetometer circuitry is driven to provide calibration measurements. For example, in some embodiments, the calibration circuitry includes heating circuitry also used to control temperature of the magnetometer (e.g., temperature of the vapor chamber). For example, in some embodiments, the calibration circuitry includes microwave antenna circuitry also configured to provide microwave stimulation for induction of magnetic resonance in the vapor chamber.

In some embodiments, the calibration circuitry is configured so that magnetic fields generated during the other function of the calibration circuitry (e.g., heating e.g., generating microwaves) are distinguishable from those magnetic fields to be measured, for example, outside a frequency bandwidth of the magnetic fields to be measured.

In some embodiments, lab calibration of the magnetometer includes measuring magnetic fields generated by the calibration circuitry using external magnetometer/s (e.g., in a controlled environment) where relationships between calibration circuitry driving signals and the magnetic field generated are determined and/or saved. Where known magnetic fields are generated by the magnetometer calibration circuitry (e.g., according to the saved relationships) and used to calibrate the magnetometer for measurement of magnetic fields e.g., in the field, the process herein termed "self-calibration".

In some embodiments, self-calibration may be used to adjust magnetometer parameters for accurate and/or optimal measurement. For example, where, in some embodiments, generation and measurement of the known calibration magnetic fields is used to identify lack of correct operation of one or more portion of the magnetometer, where parameter/s may then be adjusted e.g., prior to using the magnetometer to acquire measurements e.g., in the field.

In some embodiments, the vapor chamber is not magnetically shielded from the calibration circuitry. For example, in some embodiments, the calibration circuitry is located adjacent to the vapor chamber without shielding material therebetween.

In some embodiments, a plurality of (e.g., a set of) calibration magnetic fields are generated (e.g., sequentially) having frequencies dispersed within a range of frequencies. The range, in some embodiments, corresponding to a bandwidth of frequencies of magnetic fields to be measured by the magnetometer.

In some embodiments, for example, as the calibration may be performed in the field e.g., and not a magnetically nulled lab location, calibration magnetic fields are identified from magnetic measurements. Where, in some embodiments, e.g., calibration magnetic fields are configured to be of higher amplitude than amplitudes of expected magnetic fields in the environment. In some embodiments, for example, along with generating calibration magnetic fields with known frequencies. In some embodiments, the calibration magnetic fields are generated at known times and/or for known durations of time (e.g., as pulses). Where, in some embodiments, the known timing feature/s are used to extract measurement of the calibration magnetic fields from other magnetic fields e.g., noise and/or fields in the environment to be measured.

In some embodiments, calibration is performed by the calibration circuitry generating a set of magnetic fields (e.g., pulses including different frequencies). Where, in some embodiments, one or more of the frequencies, and pulse timing feature/s are pre-defined e.g., received from a memory. Alternatively or additionally, in some embodiments, a user specifies feature/s of the set. In some embodiments, feature/s of a pre-defined set are adjusted e.g., during a loop of an iterative calibration process.

In some embodiments, portion/s of the magnetometer circuitry (e.g., circuitry not involved in generating calibration magnetic fields) may be magnetically isolated from the vapor chamber e.g., to prevent (and/or reduce) measurement of magnetic fields generated by these circuits as noise to desired magnetic field measurement/s.

Before explaining at least one embodiment of the invention in detail, it is to be understood that the invention is not necessarily limited in its application to the details of construction and the arrangement of the components and/or methods set forth in the following description and/or illustrated in the drawings and/or the Examples. The invention is capable of other embodiments or of being practiced or carried out in various ways.

FIG. 1 is a simplified schematic of a magnetometer system **100,** according to some embodiments of the disclosure.

In some embodiments, magnetometer system **100** (herein also termed "magnetometer" or "system") includes a light source unit **102** configured to pass light **104** into a vapor chamber **106.**

In some embodiments, light emitted **136** from vapor chamber **106** is sensed by a detector **126.**

In some embodiments, magnetometer **100** includes calibration circuitry **110** which is configured to generate a plurality of magnetic fields across vapor chamber **106.** In some embodiments, calibration circuitry **110** includes a coil of conducting material.

Optionally, in some embodiments, at least a portion of the calibration circuitry also fulfils one or more role within magnetometer **100** e.g., temperature control, providing microwaves across vapor chamber **106** etc. In some embodiments, calibration circuitry **110** includes designated circuitry for calibration i.e., not performing other functions.

Function of calibration circuitry **110,** in some embodiments, is controlled by a controller **132.** Where controller **132,** in some embodiments, generates and/or sends control signals to driving circuitry **112** which then provides (e.g., based on the received control signals) driving signals for desired function of calibration circuitry **110.**

For example, in some embodiments, calibration circuitry **110** is driven in two or more modes, a calibration mode where the calibration circuitry **110** is driven to provide known magnetic field/s and a measurement mode where the calibration circuitry **110** is driven to provide other function/s.

Where, during the calibration mode, measurements of the known field/s e.g., as provided by detector **126** during the calibration mode are, in some embodiments, saved by controller **132** in a memory **116.** Although, within this document, measurement of magnetic fields is described as being provided by measurement of light e.g., by detector **126.** It should be understood, magnetic fields are measured by processing light measurements acquired e.g., upon use of a demodulation process regarding modulation driver **518** and/or detector **526** FIG. 5.

Where, during the measurement mode, calibration circuitry **110** may be driven, e.g., by driver/s **112,** according to control signals from controller **132** to provide other function/s.

In some embodiments, system **100** includes one or more user interface (UI) **130** configured to receive instructions from a user and/or display information to the user. Where, in some embodiments, a self-calibration procedure including driving calibration circuitry **110** to produce magnetic fields is initiated by a user e.g., through UI **130.**

In some embodiments, calibration circuitry **110** and one or more other magnetometer element e.g. vapor chamber **106,** light source **102,** detector **126** are housed within a magnetometer housing **114.** Optionally, one or more of controller **132,** memory **116,** and UI **130** are also housed by housing **114.**

In some embodiments, magnetometer system **100** includes a platform (not illustrated) which may provide mechanical support to housing **114.** In some embodiments, the platform is a mobile platform which may be moved from location to location. In some embodiments, the platform includes one or more actuator configured to move the platform (and thereby housing **114** and its contents). For example, in some embodiments, the platform is a vehicle.

In some embodiments, an orientation of the platform is adjustable and/or an orientation of magnetometer element/s (e.g., housing **114,** vapor chamber **108**) are adjustable e.g., with respect to Earth's magnetic field.

Optionally, in some embodiments, magnetometer system **100** includes one or more sensors (not illustrated). For example, sensor/s configured to provide measurement of movement of the magnetometer system e.g., one or more accelerometer.

FIG. 2 is a method of calibration, according to some embodiments of the disclosure.

At **200,** in some embodiments, known calibration magnetic field/s are generated, for example, with calibration circuitry of the magnetometer system. Where, in some embodiments, the calibration circuitry is configured to provide one or more other function for the system.

At **202,** in some embodiments, magnetic field measurements are acquired of the known field/s e.g., by a detector (e.g., detector **126** FIG. 1). Where, for example as described above, the detector acquires measurements of light emitted from a vapor chamber (e.g., vapor chamber **108** FIG. 1, **508** FIG. 5) which are then processed to provide measurement of magnetic field/s.

At **204**, in some embodiments, one or more parameter of the magnetometer is adjusted, based on the known calibration magnetic field/s and the magnetic field measurements.

Where, in some embodiments, measured magnetic fields (e.g., as determined from a detector signal) are compared with the known magnetic fields (generated at step **200**). The adjustment/s being based on the comparison. For example, where a mismatch between the measured and known magnetic field is above a threshold, magnetometer operational parameter/s are adjusted.

In some embodiments, the method is an iterative process, where, for example, after adjusting parameter/s at step **204,** the method is repeated e.g., until the comparison (step **204**) verifies that the magnetometer is correctly operating (e.g., within one or more allowed error range).

In some embodiments, for example, as an alternative to adjusting magnetometer parameters, calibration parameter/s associated with relationship between the measured magnetic field/s and the known magnetic fields are determined from the measurements. Where, in some embodiments, the calibration parameter/s are then used to correct acquired magnetic field measurements when the magnetometer is used.

FIG. 3 is a simplified schematic illustrating relative frequencies and amplitudes of exemplary magnetic fields, according to some embodiments of the disclosure.

FIG. 3, in some embodiments, illustrates relative exemplary frequencies and amplitudes of magnetic fields e.g., experienced by a magnetometer vapor chamber (e.g., chamber **106** FIG. 1, e.g., chamber **506** FIG. 5).

In some embodiments, the magnetometer system is configured to measure a range of frequency magnetic fields, including, in some embodiments, non-oscillating (also herein termed "DC") magnetic fields. In some embodiments, block **302** illustrates range and/or amplitude of the magnetic fields to be measured by the magnetometer. Frequencies measured being, for example, 0-1kHz, or 0-500Hz, or 0-300Hz, or lower or higher or intermediate frequencies or ranges.

Where, in some embodiments, block **306** illustrates range and/or amplitude of calibration stimulation fields produced by calibration circuitry during self-calibration of the magnetometer system.

In some embodiments, the calibration stimulation fields are oscillatory (also herein termed "AC") where the frequency of the magnetic field/s are higher than zero Hz. A potential benefit being increased accuracy e.g., in comparison to using DC calibration stimulation magnetic field/s. The increased accuracy being associated potentially with reduced DC field drift and/or flicker (1/f) noise.

In some embodiments, amplitudes of these fields are lower than that of the calibration stimulation fields e.g., so that during self-calibration where the magnetometer is being exposed to the magnetic field to be measured, the stimulation field is discernable from this magnetic field to be measured.

In some embodiments, block **304** illustrates a range of magnetic fields generated by the calibration circuitry while the calibration circuitry is providing other function/s than generation of calibration stimulation field/s e.g., heating, e.g., microwave stimulation.

Block **304,** in some embodiments, is well outside the frequency range of calibration stimulation field/s **306** and/or magnetic fields to be measured **302** Where, in some embodiments, these magnetic fields **304** have frequencies of above 100Hz, or above 500Hz, or above 1kHz.

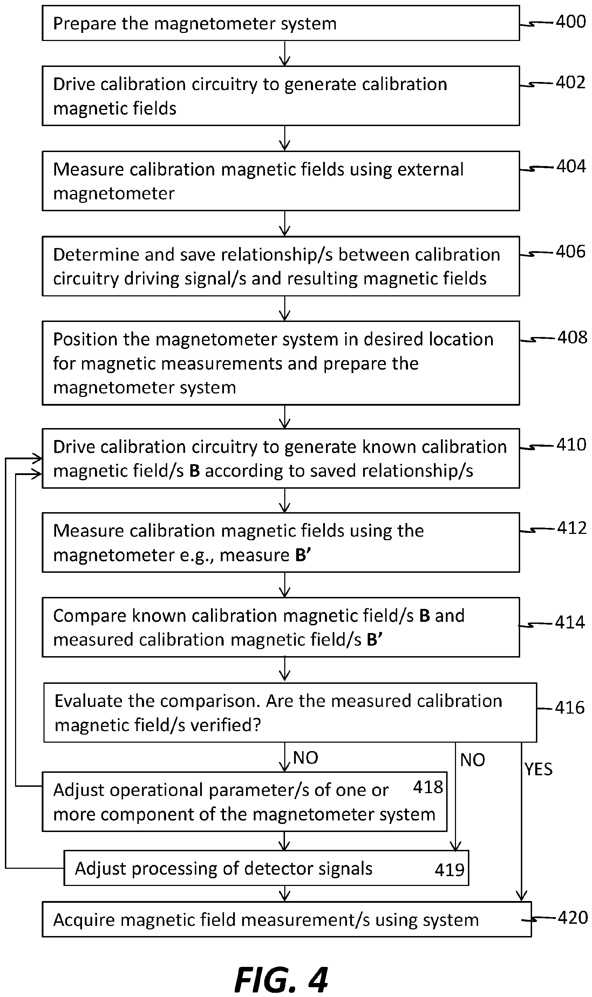

FIG. 4 illustrates a method of calibration, according to some embodiments of the disclosure.

At **400,** in some embodiments, a magnetometer system (e.g., a system including one or more feature of system **100** FIG. 1 and/or system **500** FIG. 5) is prepared.

Where, in some embodiments, preparations include one or more of, pumping the vapor chamber and heating the vapor chamber to a desired temperature.

In some embodiments, the preparation includes positioning the magnetometer system in a magnetically insulated and/or magnetically nulled space.

At **402,** in some embodiments, calibration circuitry of the magnetometer system is driven to generate calibration magnetic field/s. Where, in some embodiments, a range of driving parameters (e.g., to provide a range of different frequency and/or amplitude magnetic fields) are used (e.g., sequentially) to provide a range of calibration magnetic fields.

At **404,** in some embodiments, a magnetic field in a vicinity of the magnetometer is measured by an additional magnetometer external to the magnetometer system.

For example, where magnetic insulation and/or nulling as well as the additional magnetometer are part of a lab scene. For example, a set up for pre-calibration of existing magnetometers.

Optionally, in some embodiments, based on measurements at step **404,** steps **402** and **404** are repeated e.g., to provide additional measurements. For example, to provide higher accuracy averaged measurements and/or if a lack of data is identified and/or measurements at **404** are unexpected.

At **406,** in some embodiments, relationship/s between driving parameter/s for the calibration circuitry and the externally measured magnetic field/s are determined and/or saved. For example, to associate driving parameter/s with the resulting magnetic field/s produced. In some embodiments, this data is hosted by (e.g., saved to and/or downloaded to) the magnetometer system itself e.g., in memory circuitry thereof (e.g., memory **116** FIG. 1).

At **408,** in some embodiments, the magnetometer system is positioned and/or orientated and/or prepared.

Where the magnetometer may be positioned in a desired location and/or at a desired orientation with respect to Earth's magnetic field, and/or to a desired orientation with respect to an OPM platform.

In some embodiments, preparing the magnetometer system includes one or more of, pumping the vapor chamber and heating the vapor chamber to a desired temperature.

At **410,** in some embodiments, calibration circuitry of the system is driven to generate known calibration magnetic field/s **B** according to the determined and saved relationship/s from step **406.** In some embodiments, driving is to produce a range of magnetic fields (e.g., sequentially), for example, the range of magnetic fields having a range of different frequencies and/or amplitudes.

In some embodiments, the calibration magnetic field/s are configured to be identifiable from other magnetic field/s in the environment of the magnetometer system (e.g., the magnetic field/s to be measured, e.g., Earth's magnetic field).

Where, in some embodiments, the calibration magnetic fields have higher amplitude than expected amplitudes of the other magnetic field/s. For example, the calibration magnetic fields having amplitude of 1-20nT, or 1-10nT, or 2-5nT, or lower, or higher, or intermediate ranges, or amplitudes. Where expected amplitudes of the other magnetic field/s are, for example, 0.01-1nT, or lower or higher or intermediate amplitudes or ranges. Where, in some embodiments, the calibration magnetic fields have amplitude of at least 1.5-10 times, or lower or higher or intermediate multiples of amplitudes of other magnetic field/s.

Where, in some embodiments, calibration magnetic fields having known frequency are generated at known times and/or for known durations.

In some embodiments, calibration magnetic fields are generated as pulses e.g., of known duration and/or at known times. In an exemplary embodiment, a series of calibration magnetic field pulses, herein termed "a calibration signal set" are generated. For example, a calibration signal set may include a 10s 1nT pulse at 1Hz, followed by a 5s 7.5nT pulse at 5Hz, optionally followed by additional pulses having one or more of known duration, frequency, and amplitude.

At **412,** in some embodiments, the calibration magnetic fields **B'** are measured using the magnetometer itself.

At **414,** in some embodiments, the expected calibration magnetic field/s **B** and the measured calibration magnetic field/s **B'** are compared.

At **416,** in some embodiments, the comparison is evaluated.

In some embodiments, if the evaluation indicates that the measured fields are verified e.g., determined to be close enough to the expected magnetic fields e.g., within a threshold. In some embodiments, different frequency measurements are verified using individual thresholds which may be different.

Then, in some embodiments, the magnetometer system, **420,** is used to measure magnetic fields.

At **418,** in some embodiments, (e.g., where at **416** the measurements are not verified) based on the evaluation of the comparison at step **416,** one or more operational parameter of the magnetometer is adjusted. Where, in some embodiments, operational parameter/s include parameter/s relating to operation of one or more element of the magnetometer system.

Optionally, in some embodiments, adjustment and/or the value/s of operational parameters (e.g., for one or more iteration of a control loop including steps **410, 412, 414, 418**) are saved. Where, in some embodiments, values of operational parameter/s are saved once the measured fields are verified. In some embodiments, previously saved operational parameter/s are used as a starting point for further calibrations e.g., after a time period of use when the system is re-calibrated automatically and/or upon instruction by a user e.g., after moving and/or changing orientation of the magnetometer system.

Where operational parameter/s may include, parameter/s of the laser (e.g., laser **102** FIG. 1) and/or heating parameter/s for control of the vapor chamber temperature (e.g. vapor chamber **108** FIG. 1), and/or sensor operational parameter/s (e.g., biasing of photodiode light detector/s).

Laser parameter/s including, for example, one or more of laser power, wavelength, and characteristic/s of laser modulation signal.

At **419,** in some embodiments, digital signal processing (DSP) performed on the measurement/s is adjusted. Where the DSP includes, for example, processing steps performed on measurements to acquire magnetic field measurement/s.

In some embodiments, the DSP compensates for operational parameter/s. For example, where, in addition or alternatively to adjusting operational parameters (at step **418**), in some embodiments, DSP compensates for and/or takes into account known operational parameters and/or fluctuation thereof in processing sensor measurements to provide magnetic field measurement/s.

In some embodiments, the DSP includes extraction of magnetic resonance frequency from acquired measurements during scanning of a modulation signal e.g., scanning the modulation frequency, in some embodiments, algorithm/s (and/or parameter/s of the algorithm/s) for extraction of the magnetic resonance frequency are adjusted. Where, for example, in some embodiments, the magnetic resonance frequency is determined as a zero-crossing value of a dispersive line shape, algorithm parameter/s for extraction of the zero-crossing are adjusted.

In some embodiments, extraction of magnetic resonance at the DSP includes receiving and/or determining a line shape (for example, an ideal line shape e.g., receiving a function, e.g., a polynomial e.g., a Lorentzian function). Where, in some embodiments, the magnetic resonance is extracted by fitting the received function to the measured data. The magnetic resonance then, in some embodiments, being extracted from the fitted function e.g., zero crossing of a Lorentzian function fitted to measurement data. In some embodiments, fitting is employed using one or more fitting parameters, where one or more of the parameters may be adjusted in the calibration process e.g., the parameter/s being adjusted to provide correction to the magnetic resonance frequency extracted using the fitted function.

In some embodiments, the DSP employs data cleaning, where the acquired data and/or the function fitted to the acquired data is cleaned. For example, where the acquired data may be cleaned by truncation and/or removal of outliers. For example, where truncation, in an exemplary embodiment includes removal of the first and last data points, e.g., prior to fitting of the function to the data. A potential benefit being reduction of transient effects on the fitted function. For example, where outliers may be removed by comparison of the fitted function to the measurement data, removal or adjustment of outliers (e.g., those data points outside the fitted function over a threshold value). Where, in some embodiments, the function may then be fitted (e.g., a second time) to the measurement data after removal of outliers, the second fitted function then being used to determine the magnetic resonance frequency.

For example, where a digital lock-in amplifier is used to demodulate the photodetector measurement signals, parameter/s of the lock-in amplifier are adjusted. For example, where the lock-in amplifier is combined with a PID controller (Proportional-integral-derivative controller), parameters of one or more of the proportional, integral, and differential portions of the controller are adjusted.

In some embodiments, steps **416, 418, 419** are performed iteratively, where, for example, parameters of **418** and/or **419** are adjusted (e.g., automatically) to arrive at an optimized set of adjustment parameters.

In some embodiments operational parameter/s and/or DSP are adjusted based on known conditions (e.g., movement of the magnetometer, magnetic field gradient, etc.) of the magnetometer (e.g., sensor measurements e.g., received data). Alternatively, or additionally, in some embodiments, adjustment is to arrive at a system which provides magnetic field measurements in alignment with the calibration signals e.g., without knowledge of (or full knowledge of ) condition/s which contribute to discrepancy between the generated calibration signal and the initial magnetic field measurements.

In some embodiments, steps **410, 412, 414,** and **418** are performed a number of times e.g., automatically repeated a number (e.g., a fixed number) of times. For example, prior to performing step **416.**

At **420,** in some embodiments, magnetic field measurement/s are acquired using the magnetometer system. Optionally, the measurement/s are outputted. For example, to a user interface (e.g., UI **130** FIG. 1).

In some embodiments, calibration of the system (e.g. steps **410-418)** is re-performed e.g., periodically e.g., after a set time duration e.g., when the location and/or orientation of the magnetometer is changed e.g., upon user instruction through a user interface.

FIG. 5 is a simplified schematic of a magnetometer **500,** according to some embodiments of the disclosure.

In some embodiments, FIG. 5 illustrates exemplary details of magnetometer system **100** FIG. 1.

In some embodiments, calibration circuitry (e.g., corresponding to calibration circuitry **110** FIG. 1) is provided by a heating circuitry **510a** and/or a microwave antenna circuitry **510b.**

In some embodiments, a magnetometer controller **532** (e.g. corresponding to controller **132** FIG. 1) includes a heating driver **520** configured to control heating circuitry **510a** e.g., to maintain (e.g., including measuring) a temperature of a vapor chamber **508** (e.g., corresponding to vapor chamber **108** FIG. 1) within a desired range.

Optionally, in some embodiments, heating circuitry **510a** includes one or more temperature sensor (not illustrated) which provides feedback to controller **532** e.g., enabling closed loop control of temperature of the vapor chamber. In an exemplary embodiment, the temperature of the vapor chamber is maintained at above 60 °C (where temperature may be at higher temperatures, for example, over 150 °C), or between 55-200 °C, or between 55-150 °C, or between 55-85 °C , or lower or higher or intermediate temperatures or ranges. A potential benefit of the vapor chamber having controlled temperature being independence (and/or reduced dependence) of the magnetic field measurements acquired on ambient temperatures around the magnetometer. A potential benefit of these temperatures is increased vapor pressure (i.e., alkali atom density) in the vapor chamber.

In some embodiments, magnetometer **500** controller **532** includes a calibration signal driver **512** which is configured to drive circuitry of the magnetometer to generate magnetic field/s for self-calibration of the magnetometer. Calibration signal driver **512** driving one or both of microwave antenna circuitry **510b** and heating circuitry **510a.**

In some embodiments, magnetometer **500** includes a modulation driver **518** which is configured to provide a modulation signal to a light source unit **502** (e.g., corresponding to light source **102** FIG. 1) and/or to microwave antenna circuitry **510b.** The modulation signal for producing magnetic resonance measurements e.g., as described in more detail hereinbelow.

In embodiments where the modulation signal is provided to light source **502,** the system may lack microwave antenna circuitry **510b.** The modulation signal, for example, being provided to light source **502.**

However, embodiments including microwave antenna circuitry **510b** may include heating circuitry **510a** e.g., where calibration driver **512** may be connected to microwave antenna circuitry **510b** e.g., only and/or and not connected to heater circuitry **510a.**

In some embodiments, the calibration circuitry includes one or both microwave antenna circuitry **510b** and heating circuitry **510a.** Where, in embodiments where both circuitries **510a, 510b** are used to generate calibration magnetic fields, driving may be performed separately or together.

Calibration driving circuitry **512** may work in co-ordination with modulation driver **518** and/or a heating driver **520.** For example, where, in order for the system to produce measurement of the known magnetic field generated by calibration circuitry **510a** and/or **510b,** the calibration circuitry may be driven according to its calibration mode, in order to acquire the magnetic field measurements.

For example, where, during a same time period the heating driver **520** may be sending control signals to heating circuitry **510a** for control of temperature while the calibration driver **512** is generating signals for control of generated magnetic fields by the heating circuitry **510**a. In some embodiments, pauses in temperature control enabling the heating circuitry to generate magnetic fields for measurement are brief e.g., in comparison to a rate of heat loss from the vapor chamber **506.**

In some embodiments, housing **508** and/or a housing **514** of the magnetometer includes thermally insulating material e.g., potentially facilitating temperature control of the vapor chamber **506.**

In some embodiments, light source unit **502** (e.g., corresponding to light source 102 FIG. 1) is configured to produce circularly polarized laser light **504.** Where, in some embodiments, laser light source **502** includes a source of linearly polarized laser light (e.g., includes a VCSEL laser, or DFB/DBR laser), and one or more element configured to transform linearly polarized light into circularly polarized light **504** (for example, the element/s including optical circular polarizer/s, e.g., a *λ*/4 waveplate).

Vapor chamber **506** (e.g., corresponding to vapor chamber **106**), in some embodiments, includes a vapor chamber housing **508** which is formed of or includes transparent (e.g., to laser light) portion/s. Where light passing into vapor chamber **506** passes through a transparent portion of vapor chamber housing **508.** In some embodiments, vapor chamber housing **508,** holds a mixture **534** of vaporized alkali metal atoms and a buffer gas/es.

Exemplary alkali metals including any one of the Alkali metal atoms appearing in the first column of the periodic table and/or helium (i.e., the Alkali metals Li, Na, K, Rb, Cs and Fr). Exemplary buffer gases include N₂, Ne, Ar, Xe, and mixtures thereof.

In some embodiments, the alkali vapor is "pumped" using circularly polarized laser light **504** emitted by light source **502.** Once the alkali atoms are pumped, light outputted **536** from vapor chamber **506** is affected by the magnetic field, it is theorized, through light-matter interaction with polarized atomic spins: where alkali atoms precess, it is theorized, under a magnetic field, according to the Larmor precession frequency, which frequency is associated with the Zeeman level of the atom processing and the magnetic field strength.

In some embodiments (for example, once vapor chamber **506** is pumped by light **504)** a portion **536** of light **504** emitted by laser source **502** passes through vapor chamber **506.**

In some embodiments, magnetometer **500** includes a detector **526** (e.g., corresponding to detector **126** FIG. 1) including one or more optical sensor **526** configured to sense light **536** emanating from vapor chamber **506.** Sensor/s **526,** for example, configured to provide an electrical signal corresponding to light **536.** In some embodiments, optical sensor/s **526** include one or more photodiode. Where the photodiode/s may be configured to output an electrical signal corresponding to light received.

In some embodiments, a modulation signal, e.g., produced by modulation signal driver **518,** is scanned through a range of frequencies (continuously or with a plurality of discrete frequency values). Where a measurement signal (e.g., as provided by detector **526**) is demodulated, and a magnetic resonance frequency is extracted from the demodulated measurement signal. The magnetic resonance frequency providing a measurement of magnetic field.

Alternatively, or additionally, in some embodiments, frequency of a modulation signal is controlled using feedback of the demodulation signal, where feedback is applied to maintain the demodulated signal at a set value (e.g., corresponding to zero-crossing resonance frequency of the dispersive demodulation). Where the controlled frequency of the modulation signal is interpreted as corresponding to the resonance frequency, e.g., in a steady state.

The modulation, in some embodiments, includes frequency modulation e.g., the laser light frequency produced by light source **502** or the microwave frequency of microwaves produced by antenna/s **510**b changing with time e.g., according to a frequency of the modulation signal.

In some embodiments, frequency modulation is employed when the modulation signal is directly connected to a driver of the laser unit **502** or a driver of the microwave antenna circuitry **510b.**

In embodiments where frequency modulation is employed along with microwave stimulation of magnetic resonance, in some embodiments, a high frequency signal (e.g., near the Larmor frequency) is summed with a low frequency calibration signal. Where, in some embodiments, a unified detector sensor signal is demodulated e.g., using lock-in amplification (LIA) during extraction of the magnetic resonance frequency. Where, in some embodiments, lock-in amplification uses a PID controller (Proportional-integral-derivative controller).

In some embodiments, the modulation is via amplitude modulation e.g., where the laser amplitude or microwave amplitude is changed with time. For example, turned on and off at the modulation frequency e.g., by a chopper element which blocks the laser light on and off.

In some embodiments, the modulation is via polarization modulation e.g., where the laser circular polarization is changed with time. For example, switched from left to right polarization at the modulation frequency.

In some embodiments, a measurement signal (e.g., provided by detector **526**) is demodulated (e.g., using the modulation signal e.g., at controller **532**) to provide one or more demodulated measurement signal output with modulation frequency. Where, in some embodiments, demodulated measurement signals include one or more of an in-phase signal, a quadrature signal, a phase signal, and an amplitude signal. In some embodiments, demodulated measurement signal/s are generated by a lock-in amplifier (e.g., as an output thereof). Where, in some embodiments, the lock-in amplifier's inputs include the measurement signal and the modulation signal e.g., as references. Where the lock-in amplifier's output includes one or more of an in-phase signal, a quadrature signal, a phase signal, and an amplitude signal. Lock-in amplifier output with modulation frequency plots are also herein termed "magnetic resonance plots" and "magnetic line-shapes". In some embodiments, magnetic field strength is extracted as the resonance frequency/ies of the one or more magnetic resonance plots. For example, as a zero-crossing frequency of the dispersive line shape. Where one or both of the in-phase and quadrature signal are configured to have a dispersive line shape e.g., where a phase of the modulation signal is selected (e.g., by a user) to provide a dispersive line shape for the in-phase and/or quadrature signals).

### General

As used within this document, the term "about" refers to±20%

The terms "comprises", "comprising", "includes", "including", "having" and their conjugates mean "including but not limited to".

The term "consisting of" means "including and limited to".

As used herein, singular forms, for example, "a", "an" and "the" include plural references unless the context clearly dictates otherwise.

Within this application, various quantifications and/or expressions may include use of ranges. Range format should not be construed as an inflexible limitation on the scope of the present disclosure. Accordingly, descriptions including ranges should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within the stated range and/or subrange, for example, 1, 2, 3, 4, 5, and 6. Whenever a numerical range is indicated within this document, it is meant to include any cited numeral (fractional or integral) within the indicated range.

It is appreciated that certain features which are (e.g., for clarity) described in the context of separate embodiments, may also be provided in combination in a single embodiment. Where various features of the present disclosure, which are (e.g., for brevity) described in a context of a single embodiment, may also be provided separately or in any suitable sub-combination or may be suitable for use with any other described embodiment. Features described in the context of various embodiments are not to be considered essential features of those embodiments, unless the embodiment is inoperative without those elements.

Although the present disclosure has been described in conjunction with specific embodiments thereof, it is evident that many alternatives, modifications, and variations will be apparent to those skilled in the art. Accordingly, this application intends to embrace all such alternatives, modifications and variations that fall within the broad scope of the appended claims.

All references (e.g., publications, patents, patent applications) mentioned in this specification are herein incorporated in their entirety by reference into the specification, e.g., as if each individual publication, patent, or patent application was individually indicated to be incorporated herein by reference. Citation or identification of any reference in this application should not be construed as an admission that such reference is available as prior art to the present disclosure. In addition, any priority document(s) and/or documents related to this application (e.g., co-filed) are hereby incorporated herein by reference in its/their entirety.

Where section headings are used in this document, they should not be interpreted as necessarily limiting.

## Claims

1. An optically pumped magnetometer (OPM) having a vapor chamber, a light source configured to supply light to said vapor chamber, a detector positioned to measure light emitted from said vapor chamber, and comprising:
calibration circuitry configured to generate magnetic fields having a plurality frequencies across said vapor chamber; and
a controller operatively coupled to the calibration circuitry and configured to, in a calibration mode:
generate a calibration circuitry control signal configured to drive said calibration circuitry to sequentially to generate a set of known magnetic fields with predefined frequencies;
receive, from said detector, a plurality of detector measurements, each measurement corresponding to a known magnetic field of said set;
determine a calibration error of said OPM using said set of known magnetic fields and said plurality of detector measurements.

2. The OMP according to claim 1, wherein said controller is configured to adjust one or more operational parameter of said OPM to reduce said calibration error.

3. The OPM according to any one of claims 1-2, wherein said controller is configured to determine said calibration error by:
processing said plurality of detector measurements to determine a plurality of magnetic field measurements; and
comparing said plurality of magnetic field measurements with said set of known magnetic fields.

4. The OPM according to claim 3, wherein one or more of:
said controller is configured to adjust said processing to reduce said calibration error; and
said processing comprises one or more of:
fitting an ideal function to each said set, where said magnetic field measurement is extracted using said fitted ideal function; and
truncating said measurement data.

5. The OPM according to claim 4, wherein said controller is configured to adjust one or more parameter of said fitting.

6. The OMP according to any one of claims 1-5, comprising a housing hosting at least said vapor chamber, and said calibration circuitry.

7. The OPM according to claim 6, wherein said housing hosts said light source and said detector.

8. The OPM according to any one of claims 1-7, wherein said controller is configured to:
receive calibration parameters from a memory;
generate said calibration circuitry control signal using said calibration parameters.

9. The OPM according to any one of claims 2-8, wherein one or more of:
said controller is configured to: extract, for each of said plurality of detector measurements, a resonance frequency; and determine a magnetic field measurement from said resonance frequency;
when said OPM is in said calibration mode, said controller is configured to iteratively perform generation and measurement of known magnetic fields, and adjustment of said one or more operational parameter of said magnetometer and/or to perform adjustment of processing of detector measurements until said calibration error is below a threshold.

10. The OPM according to claim 9, wherein said controller is configured to:
control a modulation signal;
extract, for each of said plurality of detector measurements, said resonance frequency, using said modulation signal.

11. The OPM according to claim 10, wherein said modulation signal is a signal configured to modulate a frequency of light emitted by said light source; or
said modulation signal is a signal configured to modulate a frequency of microwaves emitted by a microwave antenna.

12. The OPM according to any one of claims 1-11, wherein one or more of:
said controller is configured to determine a calibration error for each of said set of known magnetic fields by comparison with a corresponding magnetic field measurement; and
said predefined frequencies are distributed within a calibration magnetic signal bandwidth, where said calibration magnetic signal bandwidth corresponds to a desired measurement bandwidth of said OPM.

13. The OPM according to claim 12, wherein one or more of:
said calibration circuitry comprises at least one element providing an additional function, where when said at least one element is driven to provide said additional function, magnetic fields generated are outside said calibration magnetic signal bandwidth; and
said magnetic fields generated are of frequencies above 1kHz, or above 3kHz;
said measurement bandwidth of said OPM includes frequencies below 1kHz;
said at least one element comprises heating circuitry configured to control temperature of said vapor chamber;
said at least one element comprises microwave antenna circuitry configured to generate microwaves to induce magnetic resonance within said vapor chamber; and
said calibration circuitry is adjacent to said vapor chamber without magnetically shielding material therebetween.

14. The OPM according to any one of claims 2-13, wherein one or more of:
said one or more operational parameter includes one or more parameter of said light source, and one or more parameter of said detector;
said set of known magnetic fields comprise pulses have one or more of a known time and a known duration, where said controller is configured to extract, for one or more pulse, a corresponding detector measurement, using said known time and/or known duration; and
said set of known magnetic fields have higher amplitude than fields to be measured by said OPM.

15. A method of optically pumped magnetometer (OPM) calibration to be performed in the field comprising:
driving calibration circuitry of the OPM to sequentially generate a set of known magnetic fields with predefined frequencies;
receiving, from a detector of the OPM, a plurality of detector measurements, each measurement corresponding to a known magnetic field of said set;
determining a calibration error of said OPM using said set of known magnetic fields and said plurality of detector measurements.
